# EUROPÄISCHE PATENTSCHRIFT

(11) **EP 1 729 138 B1**
(45) Veröffentlichungstag und Bekanntmachung des Hinweises auf die Patenterteilung: **29.09.2010**
(21) Anmeldenummer: 06010739.8
(22) Anmeldetag: 24.05.2006
(51) Int. Cl.: G01R 31/08

(54) **Verfahren und Vorrichtung zum Ermitteln des Ortes eines Kurzschlusses in einer Leitung eines Energieversorgungsnetzes**
Method and device for determining the location of a short circuit in a line of an energy supply network
Procédé et dispositif destinés à déterminer l'endroit d'un court circuit dans un circuit de réseau d'alimentation d'énergie

(30) Priorität: 27.05.2005 DE 102005024483
(43) Veröffentlichungstag der Anmeldung: 06.12.2006
(73) Patentinhaber: RBS Wave GmbH, 70173 Stuttgart (DE)
(72) Erfinder: Klütz, Robert, 70794 Filderstadt (DE); Schwach, Matthias, 70771 Leinfelden-Echterdingen (DE)
(74) Vertreter: Dreiss

(56) Entgegenhaltungen:
- EP-A- 1 249 806
- DE-A1- 10 309 197
- GB-A- 2 348 553
- ROSENBERGER R ET AL: "VERTEILNETZAUTOMATION - LOESUNGEN FUER DEN KOSTENEFFIZIENTEN NETZBETRIEB" ENERGIETECHNIK, LEIPZIG, DE, Nr. 22, 2001, Seiten 18-24, XP008032282 ISSN: 0013-7421

## Beschreibung

### Stand der Technik

Die Erfindung betrifft ein Verfahren und eine Vorrichtung zum Ermitteln des Ortes eines Kurzschlusses in einer Leitung eines Energieversorgungsnetzes, wobei die Leitung mit mindestens einer Übergabestation verbunden ist, und wobei in der Übergabestation ein GSM-Modul vorhanden ist, das in ein Mobilfunk-Netz eines Mobilfunk-Betreibers eingebucht werden kann.

Ein derartiges System ist aus der DE 103 09 197 A1 bekannt. Dort ist ein Kurzschlussanzeiger vorgesehen, mit dem ein Kurzschlussstrom auf einer Leitung erkannt werden kann. Im Falle eines erkannten Kurzschlusses wird ein GSM-Modul (GSM = global system for mobile communications, globales Mobilfunk-Kommunikationssystem) in das Mobilfunk-Netz eines Mobilfunk-Betreibers eingebucht. Danach wird von dem GSM-Modul eine Kurzschluss-SMS (sms = short message service, Mobilfunk-Kurznachrichtendienst) an eine Zentrale versendet. Diese Kurzschluss-SMS kann in der zentrale dazu herangezogen werden, um auf den Ort des Kurzschlusses zu schließen.

Zum versenden der Kurzschluss-SMS ist es erforderlich, dass in der näheren örtlichen Umgebung des sendenden GSM-Moduls eine Mobilfunk-Antenne des Mobilfunk-Betreibers vorhanden ist. Weiterhin ist es erforderlich, dass diese Mobilfunk-Antenne funktionsfähig ist. Hierzu muss die Mobilfunk-Antenne mit elektrischer Energie versorgt werden.

Ein Kurzschluss in einer Leitung eines Energieversorgungsnetzwerks kann zur Folge haben, dass die Leitung abgeschaltet wird und damit zumindest vorübergehend keine elektrische Energie mehr über die Leitung übertragen wird. Ist nun die Mobilfunk-Antenne an diese Leitung angeschlossen, so bedeutet dies, dass die Mobilfunk-Antenne vorübergehend nicht funktionsfähig ist.

Da es, wie erwähnt wurde, zur Übermittlung der Kurzschluss-SMS erforderlich ist, dass eine Mobilfunk-Antenne in der Nähe des GSM-Moduls vorhanden ist, besteht eine Wahrscheinlichkeit dafür, dass diese Mobilfunk-Antenne gerade über diejenige Übergabestation oder zumindest über die zugehörige Leitung mit Energie versorgt wird, in der ein Kurzschluss aufgetreten ist. Die für die Übermittlung der Kurzschluss-SMS erforderliche Mobilfunk-Antenne ist damit aufgrund dieses Kurzschlusses funktionsunfähig.

Dies bedeute aber, dass das Verfahren nach der DE 103 09 108 A1 in diesem Fall gerade nicht in der Lage ist, den erkannten Kurzschluss mittels einer Kurzschluss-SMS an die Zentrale zu melden. Der Ort des Kurzschlusses kann somit nicht ermittelt werden.

Weiterer Stand der Technik ist aus der GB-A-2 348 553 benannt, sowie aus ROSENBERGER R ET AL: "VERTEILNETZAUTOMATION - LÖSUNGEN FÜR DEN KOSTENEFFIZIENTEN NETZBETRIEB" ENERGIETECHNIK, LEIPZIG, DE, Nr. 22, 2001, Seiten 18 - 24, XP008032282 ISSN: 0013-7421.

### Aufgabe und Lösung der Erfindung

Aufgabe der vorliegenden Erfindung ist es, ein Verfahren zum Ermitteln des Ortes eines Kurzschlusses in einer Leitung eines Energieversorgungsnetzes zu schaffen, das auch dann funktioniert, wenn das Energieversorgungsnetz oder Teile davon beispielsweise aufgrund des Kurzschlusses vorübergehend abgeschaltet wird.

Diese Aufgabe wird bei einem Verfahren der eingangs genannten Art erfindungsgemäß dadurch gelöst, dass das GSM-Modul der Übergabestation fortlaufend in das Mobilfunk-Netz des Mobilfunk-Betreibers eingebucht ist, dass bei einem Kurzschluss eine Statusabfrage-SMS an das GSM-Modul der Übergabestation gesendet wird, dass überwacht wird, ob das Versenden der Statusabfrage-SMS mit einer Fehler-Nachricht des Mobilfunk-Betreibers beantwortet wird, und dass, sofern eine Fehler-Nachricht empfangen wird, der Ort des Kurzschlusses in Abhängigkeit von der erhaltenen Fehler-Nachricht ermittelt wird. Bei einer Vorrichtung der eingangs genannten Art wird die Aufgabe erfindungsgemäß entsprechend gelöst.

Mit dem erfindungsgemäßen Verfahren wird erkannt, dass zu dem GSM-Modul, an das die Statusabfrage-SMS versendet worden ist, momentan keine Funkverbindung aufgebaut werden kann. Da das GSM-Modul als solches aufgrund der unterbrechungsfreien Stromversorgung und der fortlaufenden Einbuchung in das Mobilfunk-Netz des Mobilfunk-Betreibers als funktionsfähig angenommen werden kann, kann aus der Fehler-Nachricht abgeleitet werden, dass andere Komponenten, die für den Aufbau der Funkverbindung erforderlich sind, ausgefallen sind. Dies kann wiederum auf den vorhandenen Kurzschluss und einen daraus gegebenenfalls resultierenden Ausfall der Energieversorgung zurückgeführt werden. Diese Erkenntnisse können dann für die Ermittlung des Orts des Kurzschlusses herangezogen werden.

Insbesondere kann aus einer erhaltenen Fehler-Nachricht geschlossen werden, dass in derjenigen Übergabestation, an die die Statusabfrage-SMS gerichtet war, selbst dann ein Kurzschluss vorhanden sein kann, wenn von dort kein Kurzschluss gemeldet wird. Die Übergabestation, an die die mit der Fehler-Nachricht beantwortete Statusabfrage-SMS gerichtet war, darf damit nicht von der weiteren Ermittlung des Orts des Kurzschlusses ausgeschlossen werden, sondern muss bei dieser Ermittlung weiter berücksichtigt werden.

Durch das erfindungsgemäße Vorgehen wird somit vermieden, dass eine Übergabestation bei der Ermittlung des Ortes eines Kurzschlusses unberücksichtigt bleibt, obwohl der Kurzschluss dort vorhanden sein kann. Damit wird die Zuverlässigkeit der genannten Ortsermittlung verbessert. Insbesondere wird der mit einem Suchen des Kurzschlusses verbundene Aufwand vermieden.

Bei einer vorteilhaften Weiterbildung des erfindungsgemäßen Verfahrens wird aus dem Empfang einer Fehler-Nachricht abgeleitet, dass diejenige Mobilfunk-Antenne des Mobilfunk-Betreibers aufgrund des Kurzschlusses nicht funktionsfähig ist, die in der näheren örtlichen Umgebung der Übergabestation vorhanden ist, an die die Statusabfrage-SMS gerichtet war, und es wird der Ort des Kurzschlusses in Abhängigkeit von der nicht-funktionsfähigen Mobilfunk-Antenne ermittelt.

Mit dieser Weiterbildung wird ein möglicher Grund dafür berücksichtigt, dass die Funkverbindung zu der bestimmten Übergabestation nicht aufgebaut werden kann. Bei diesem Grund handelt es sich darum, dass gerade diejenige Mobilfunk-Antenne aufgrund des Kurzschlusses ausgefallen ist, die zum Aufbau der Funkverbindung zu der bestimmten Übergabestation erforderlich ist. Der Ort des Kurzschlusses kann in diesem Fall dadurch näher ermittelt werden, dass der Ort der ausgefallenen Mobilfunk-Antenne berücksichtigt wird.

Bei einer vorteilhaften Ausgestaltung des erfindungsgemäßen Verfahrens wird ein Kurzschluss auf der Leitung über dieselbe Leitung gemeldet, und es wird die Statusabfrage-SMS versendet, nachdem ein Kurzschluss über die Leitung gemeldet worden ist. Mit Hilfe des gemeldeten Kurzschlusses wird somit die Versendung der Statusabfrage-SMS ausgelöst.

Bei einer weiteren vorteilhaften Ausgestaltung des erfindungsgemäßen Verfahrens kann ein Kurzschluss in der Übergabestation erkannt werden, und es wird bei einem erkannten Kurzschluss von dem GSM-Modul der Übergabestation eine Kurzschluss-SMS versendet. Aus den empfangenen Kurzschluss-SMS's kann dann auf den Ort des Kurzschlusses geschlossen werden.

### Ausführungsbeispiele der Erfindung

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

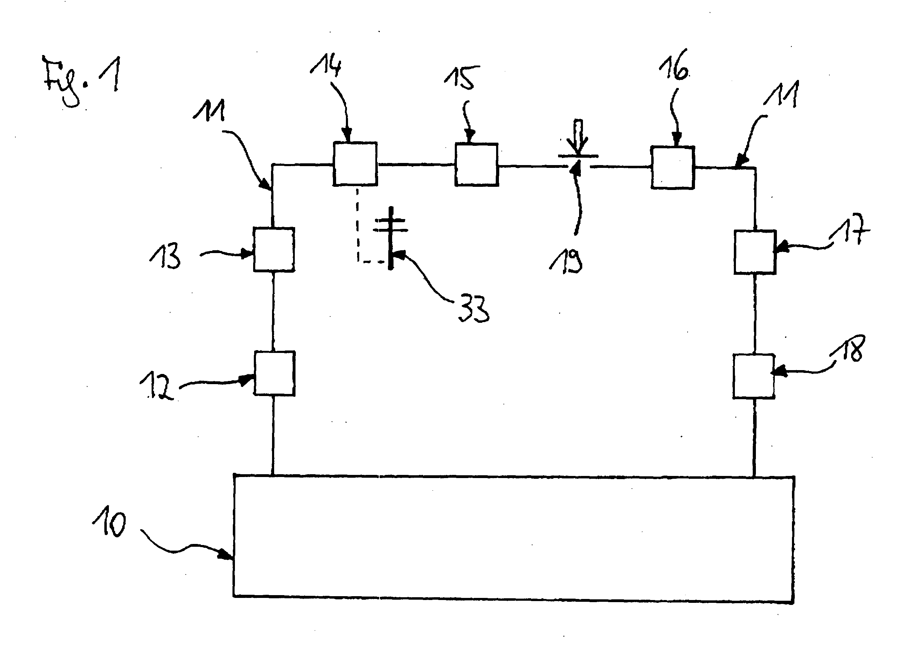

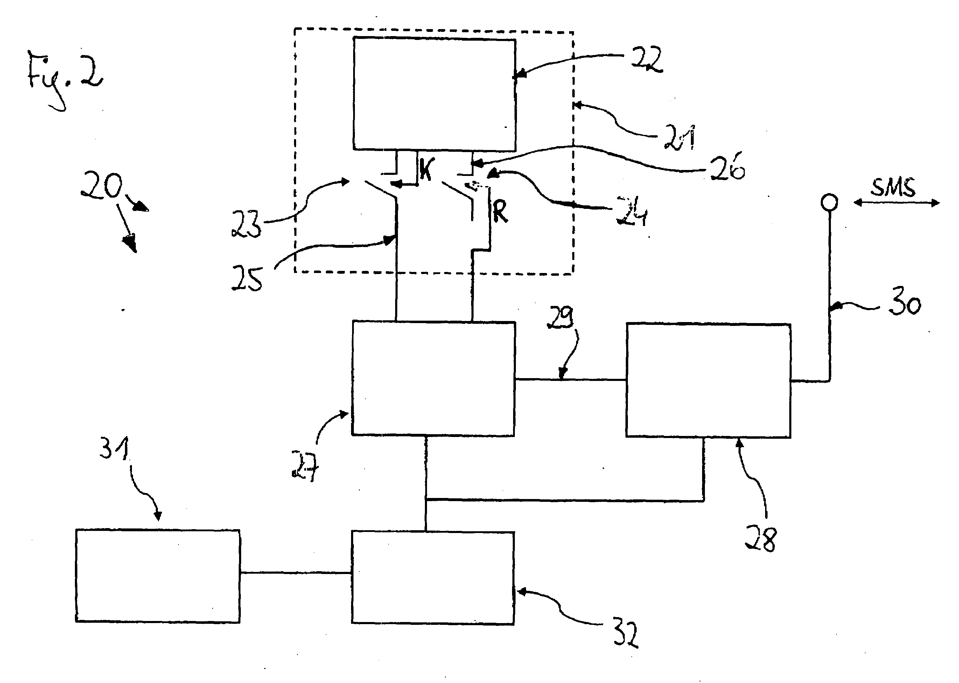

Figur 1 zeigt ein schematisches Blockschaltbild eines Ausführungsbeispiels eines lokalen elektrischen Energieversorgungsnetzes mit einer Mehrzahl von Übergabestationen, und Figur 2 zeigt ein schematisches Blockschaltbild eines Ausführungsbeispiels einer erfindungsgemäßen Einrichtung zur Anzeige eines Kurzschlusses in einer Übergabestation.

In der Figur 1 ist ein Umspannwerk 10 dargestellt, das ein Bestandteil eines Energieversorgungsnetzes ist. Von dem Umspannwerk 10 geht eine Leitung 11 aus, über die eine Mehrzahl von übergabestationen 12, 13, 14, 15, 16, 17, 18 mit elektrischer Energie versorgt werden, beispielsweise mit einer Mittelspannung von 10 kV. Hierzu weist die Leitung 11 drei Phasen auf. In den Übergabestationen 12, 13, 14, 15, 16, 17, 18 wird die Mittelspannung auf eine Netzspannung von beispielsweise 400 V umgesetzt. In der Leitung 11 ist ein Trenner 19 enthalten, der im Normalbetrieb üblicherweise in seine gezeigte, geöffnete Stellung geschaltet ist.

In der Figur 2 ist eine Einrichtung 20 dargestellt, die in jeder der Übergabestationen vorhanden sein kann. Es wird nachfolgend davon ausgegangen, dass die Einrichtung 20 beispielhaft zumindest in den Übergabestationen 12, 13, 14, und 15 vorhanden ist.

Die Einrichtung 20 weist einen Kurzschlussanzeiger 21 auf, der zumindest eine Schaltung 22 zur Erkennung eines Kurzschlusses sowie einen Meldekontakt 23 und einen Rückstellkontakt 24 umfasst. Die Schaltung 22 des Kurzschlussanzeigers 21 mit dem zugehörigen Meldekontakt 23 und Rückstellkontakt 24 kann allen drei Phasen der Leitung 11 oder auch nur einer einzelnen Phase zugeordnet sein. Im zweiten Fall sind dann zweckmäßigerweise drei Kurzschlussanzeiger vorhanden. Alternativ oder zusätzlich können auch noch entsprechende Erdschlussanzeiger vorhanden sein.

Die Schaltung 22 des Kurzschlussanzeigers 21 ist dazu vorgesehen und geeignet, einen im Bereich der zugehörigen Übergabestation vorhandenen Kurzschlussstrom festzustellen. In Abhängigkeit von der Zuordnung des jeweiligen Kurzschlussanzeigers 21 kann es sich um einen dreiphasigen oder einphasigen Kurzschluss oder um einen Erdschluss handeln.

Wird ein Kurzschlussstrom erkannt, so wird der Meldekontakt 23 von der Schaltung 22 mit Hilfe eines Signals K von seiner dargestellten geöffneten Normalstellung in eine geschlossene Stellung umgeschaltet. Auf der von dem Meldekontakt abgehenden Leitung 25 liegt dann zumindest kurzzeitig ein Kurzschlusssignal an, das den erkannten Kurzschluss kennzeichnet.

Mit dem Rückstellkontakt 24 kann der Meldekontakt 23 wieder in seine geöffnete Normalstellung zurückgeschaltet werden. Hierzu muss ein Signal R erzeugt werden, mit dem der Rückstellkontakt 24 zumindest kurzzeitig von seiner dargestellten geöffneten Normalstellung in eine geschlossene Stellung umgeschaltet wird. Dies hat dann zur Folge, dass über die von dem Rückstellkontakt 24 abgehende Leitung 26 ein Rückstellsignal an die Schaltung 22 weitergegeben wird. Dieses Rückstellsignal bewirkt schließlich, dass der Meldekontakt 23 von der Schaltung 22 mit Hilfe des Signals K wieder in seine geöffnete Normalstellung geschaltet wird.

Die Einrichtung 20 weist eine Steuereinheit 27 auf, die vorzugsweise einen Mikrocomputer oder eine speicherprogrammierte Steuerung oder vergleichbare Mittel umfasst, die dazu vorgesehen und geeignet sind, Eingangssignale zu empfangen, zu verarbeiten und in Abhängigkeit davon Ausgangssignale zu erzeugen. Vorliegend wird die Steuereinheit 27 über die Leitung 25 mit dem Kurzschlusssignal beaufschlagt. Weiterhin kann die Steuereinheit 27, sofern erforderlich, das Signal R für die Schaltung 22 des Kurzschlussanzeigers 21 erzeugen.

Die Einrichtung 20 weist ein GSM-Modul 28 auf (GSM = global system for mobile communications, globales Mobilfunk-Kommunikationssystem). Das GSM-Modul 28 ist über eine Leitung 29 mit der Steuereinheit 27 verbunden. Im einfachsten Fall kann es sich bei dem GSM-Modul 28 um ein Mobiltelefon handeln, das über die Leitung 29 Daten bzw. Informationen von der Steuereinheit 27 erhalten bzw. an diese übermitteln kann.

Das GSM-Modul 28 ist mit einer Antenne 30 gekoppelt, über die das GSM-Modul 28 zumindest sogenannte SMS's (SMS = short message service, Mobilfunk-Kurznachrichtendienst) versenden und empfangen kann. Die Antenne 30 kann in das GSM-Modul 28 integriert oder extern angeordnet sein.

Die Einrichtung 20 weist ein Netzteil 31 auf, das mit einer USV 32 (USV = unterbrechungsfreie Stromversorgung) gekoppelt ist. Das Netzteil 31 ist beispielsweise an die 230V-Spannung angeschlossen. Im Normalbetrieb versorgt das Netzteil 31 die Steuereinheit 27 und das GSM-Modul 28 mit Energie. Im Falle eines Ausfalls der 230V-Spannung, beispielsweise im Falle eines Kurzschlusses und einer daraus resultierenden Abschaltung der Energieversorgung, übernimmt die USV 32 die Energieversorgung der Steuereinheit 27 und des GSM-Moduls 28. Der Übergang der Energieversorgung von dem Netzteil 31 auf die USV 32 erfolgt dabei mit einer derart geringen Zeitverzögerung, dass der Betrieb der Steuereinheit 27 und des GSM-Moduls 28 weder durch den Ausfall des Netzteils 31 und dadurch der Energieversorgung, noch durch den Übergang der Energieversorgung auf die USV 32 gestört wird.

Die Steuereinheit 27 und das GSM-Modul 28 sind fortlaufend eingeschaltet und damit jederzeit funktionsbereit. Weiterhin ist das GSM-Modul 28 fortlaufend in ein Mobilfunk-Netz eines Mobilfunk-Betreibers eingebucht, so dass jederzeit von dem GSM-Modul 28 eine SMS versendet oder empfangen werden kann.

wird von der Schaltung 22 des Kurzschlussanzeigers 21 ein Kurzschluss erkannt und über den Meldekontakt 23 und die Leitung 25 an die Steuereinheit 27 gemeldet, so steuert die Steuereinheit 27 das GSM-Modul 28 derart an, dass von dem GSM-Modul 28 eine Kurzschluss-SMS versandt wird. In der Steuereinheit 27 oder in dem GSM-Modul 28 ist dabei eine Telefonnummer vorgegeben, an die die Kurzschluss-SMS gerichtet ist. Dabei kann es sich ganz allgemein um eine Zentrale, beispielsweise um ein zentrales Alarm-Telefon in dem Umspannwerk 10 handeln, und zwar insbesondere um ein Mobiltelefon, das fortlaufend in ein Mobilfunk-Netz eingebucht ist. Weiterhin ist das GSM-Modul 28 derart eingestellt, dass die Telefonnummer des GSM-Moduls 28 dem Empfänger der Kurschluss-SMS mitgeteilt wird.

Die von dem GSM-Modul 28 versendete Kurzschluss-SMS kann folgende Informationen enthalten. In Abhängigkeit von demjenigen Kurzschlussanzeiger, der den Kurzschluss erkannt hat, kann die Kurzschluss-SMS eine Angabe enthalten, ob es sich um einen dreiphasigen oder einen einphasigen Kurzschluss oder um einen Erdschluss handelt. Bei einem einphasigen Kurzschluss kann die betroffene Phase mit einer Nummer gekennzeichnet sein. Weiter kann die Kurzschluss-SMS Angaben enthalten, die sich auf die Dauer des Kurzschlusses beziehen. So kann durch eine entsprechende Ansteuerung des Rückstellkontaktes festgestellt werden, ob es sich um einen nur kurzzeitig vorhandenen Kurzschluss oder um einen permanenten Kurzschluss handelt. Gegebenenfalls können auch noch weitere Angaben in die Kurzschluss-SMS eingebunden werden, mit denen der aktuelle Zustand im Bereich der jeweiligen Übergabestation näher darstellbar ist.

Beim Empfänger können die vorgenannten Informationen aus der Kurzschluss-SMS wieder entnommen und verwertet werden. Weiterhin kann der Empfänger aufgrund der mitgeteilten Telefonnummer des sendenden GSM-Moduls 28 die empfangenen Informationen derjenigen Übergabestation zuordnen, zu der das sendende GSM-Modul 28 gehört.

Es wird nachfolgend davon ausgegangen, dass in der Übergabestation 14 ein Kurzschluss auftritt. Das Vorhandensein dieses Kurzschlusses wird dem Umspannwerk 10 über die Leitung 11, also unabhängig von den vorstehenden Erläuterungen, gemeldet. Diese Meldung betrifft jedoch nur den umstand, dass irgendwo auf der Leitung 11 ein Kurzschluss vorhanden ist. Mit der vorstehenden Annahme kann damit aus der Meldung nur abgeleitet werden, dass auf der Leitung 11 im Bereich der Übergabestationen 12, 13, 14, 15 ein Kurzschluss vorhanden ist. Aus der Meldung kann jedoch nicht auf den genauen Ort des Kurzschlusses geschlossen werden.

Der Kurzschluss in der Übergabestation 14 hat zur Folge, dass der Kurzschlussanzeiger 21 in der Übergabestation 14 einen Kurzschluss erkennt. Weiterhin erkennen auch sämtliche Kurzschlussanzeiger 21 in denjenigen Übergabestationen 12, 13 einen Kurzschluss, die zwischen der Übergabestation 14 und dem Umspannwerk 10 angeordnet sind. Diejenige Übergabestation 15, die aus Sicht des Umspannwerks 10 nach der Übergabestation 14 angeordnet ist, erkennt jedoch keinen Kurzschluss. Dies ergibt sich daraus, dass bei einem Kurzschluss in der Übergabestation ein Kurzschlussstrom von dem Umspannwerk 10 über die Übergabestationen 12, 13 zu der Übergabestation 14 fließt und dort abgeleitet wird. Der Kurzschlussstrom gelangt jedoch annahmegemäß nicht zur Übergabestation 15.

In den Einrichtungen 20 der Übergabestationen 12, 13, 14 wird somit jeweils ein Kurzschlusssignal erzeugt und über die Leitung 25 an die Steuereinheit 27 weitergegeben. Die Steuereinheit 27 veranlasst daraufhin das jeweilige GSM-Modul 28 zur Versendung einer Kurzschluss-SMS mit den jeweils zugehörigen Informationen. All diese Kurzschluss-SMS's werden beispielsweise von dem Alarm-Telefon im Umspannwerk 10 empfangen. Über die mitgeteilten Telefonnummern der sendenden GSM-Module 28 können die unterschiedlichen Kurzschluss-SMS's den jeweils zugehörigen Übergabestationen 12, 13, 14 zugeordnet werden.

Damit kann im Umspannwerk 10 anhand der empfangenen Kurzschluss-SMS's nachvollzogen werden, in welchen Übergabestationen ein Kurzschluss erkannt worden isc. Im vorliegenden Beispielfall kann somit im Umspannwerk 10 erkannt werden, dass in den Übergabestationen 12, 13, 14 ein Kurzschluss vorliegt.

Weiterhin kann im Umspannwerk 10 festgestellt werden, dass von der Übergabestation 15 keine Kurzschluss-SMS eingegangen ist. Dies bedeutet, dass im Bereich der Übergabestation 15 kein Kurzschluss vorhanden ist.

Aus diesen Informationen kann abgeleitet werden, dass der Ort des Kurzschlusses mit hoher Wahrscheinlichkeit im Bereich der Übergabestation 14 liegt. Dies ergibt sich daraus, dass die Übergabestation 14 aus der Sicht des Umspannwerks 10 die letzte derjenigen Übergabestationen 12, 13, 14 darstellt, die einen Kurzschluss erkannt und gemeldet haben.

Bekannter weise ist ein Mobilfunk-Netz aus einer Vielzahl von Funkzellen aufgebaut, die zusammen dasjenige Gebiet bilden, in dem das Mobilfunk-Netz vorhanden und nutzbar ist. Jede der Funkzellen deckt dabei ein lokal begrenztes Teilgebiet mit einem Radius von beispielsweise etwa 3 Kilometern ab. In städtischen oder ländlichen Gegenden kann dieser Radius auch kleiner oder größer sein. Innerhalb jeder der Funkzellen ist eine von dem Mobilfunk-Betreiber aufgestellte Mobilfunk-Antenne vorhanden, über die eine Funkverbindung zu all denjenigen Mobiltelefonen aufgebaut werden kann, die sich innerhalb der zugehörigen Funkzelle befinden. Von der Mobilfunk-Antenne werden die Verbindungen dann beispielsweise an das leitungsgebundene Telefonnetz weitergegeben.

Die für den Betrieb des Mobilfunk-Netzes innerhalb einer Funkzelle verantwortliche Mobilfunk-Antenne muss mit Energie versorgt werden. Hierzu ist die Mobilfunk-Antenne beispielsweise an die 230V-Spannung angeschlossen.

Üblicherweise ist diese Energieversorgung nicht mit einer unterbrechungsfreien Stromversorgung oder einer sonstigen Einrichtung gekoppelt, mit der bei einem Ausfall der 230V-Spannung die Mobilfunk-Antenne weiterbetrieben werden könnte.

Dies hat zur Folge, dass bei einem Ausfall der 230v-Spannung die Mobilfunk-Antenne üblicherweise nicht mehr betriebsfähig ist. Es können damit in diesem Fall keine Funkverbindungen mehr zu irgendwelchen Mobiltelefonen aufgebaut werden, die sich in der zu der Mobilfunk-Antenne zugehörigen Funkzelle befinden.

Es wird nunmehr angenommen, dass sich die Übergabestation 14 in einer Funkzelle des Mobilfunk-Netzes befindet, zu dem die in der Figur 1 schematisch eingezeichnete Mobilfunk-Antenne 33 gehört, und dass diese Mobilfunk-Antenne 33 von der Übergabestation 14 mit Energie versorgt wird. Weiterhin wird angenommen, dass jegliche anderen Mobilfunk-Antennen, über die Funkverbindungen zu den GSM-Modulen der anderen Übergabestationen 12, 13, 15 vorhanden sind, nicht über die Leitung 11 mit Energie versorgt werden.

Diese Annahmen haben zur Folge, dass bei einem Kurzschluss im Bereich der Übergabestation 14 und einer gegebenenfalls daraus resultierenden vorübergehenden Abschaltung der Energieversorgung die Mobilfunk-Antenne nicht mehr funktionsfähig ist. Damit kann zwischen dem GSM-Modul 28 der Übergabestation 14 und der Mobilfunk-Antenne 33 keine Funkverbindung mehr aufgebaut werden. Die Funkverbindungen zu den anderen Übergabestationen sind jedoch trotz des Kurzschlusses unverändert vorhanden. Damit kann von dem GSM-Modul 28 der Übergabestation 14 keine Kurzschluss-SMS ausgesendet werden. Im Umspannwerk 10 wäre es somit auf der Grundlage des bisher beschriebenen Verfahrens aufgrund der fehlenden Kurzschluss-SMS nicht möglich, den Ort des Kurzschlusses korrekt zu ermitteln.

Wie erläutert wurde, erhält das Umspannwerk 10 eine Meldung über die Leitung 11, sofern auf der Leitung 11 ein Kurzschluss vorhanden ist. Aus der Meldung geht jedoch nicht der Ort des Kurzschlusses hervor.

Sobald die vorstehende Meldung im Umspannwerk 10 eingegangen ist, wird beispielsweise von dem Alarmtelefon im Umspannwerk an jede der Übergabestationen 12, 13, 14, 15 eine Statusabfrage-SMS verschickt. Die Telefonnummern der GSM-Module 28 in den jeweiligen Übergabestationen sind dabei vorgegeben und im Umspannwerk 10 bekannt.

Der Inhalt der Statusabfrage-SMS ist an sich nur von zweitrangiger Bedeutung. Gegebenenfalls kann es sich bei dem Inhalt um eine Aufforderung des Alarmtelefons an die Übergabestationen handeln, dass diese eine Antwort-SMS an das Alarmtelefon versenden.

Besteht zwischen dem GSM-Modul 28 der jeweiligen Übergabestation und der zugehörigen Mobilfunk-Antenne eine Funkverbindung, wie dies annahmegemäß für die Übergabestationen 12, 13, 15 der Fall ist, so kann die von dem Alarmtelefon versendete Statusabfrage-SMS von dem GSM-Modul 28 empfangen werden. Dies hat zur Folge, dass das Alarmtelefon keine Antwort erhält, oder, in Abhängigkeit von dem Inhalt der Statusabfrage-SMS, die erwünschte Antwort-SMS zurückerhält.

Wesentlich ist, dass das Alarmtelefon bei bestehender Funkverbindung von dem Mobilfunk-Betreiber keine Fehler-Nachricht erhält. Sofern also die von dem Alarmtelefon ausgesendete Statusabfrage-SMS von dem GSM-Modul 28 der Übergabestationen 12, 13, 15 empfangen wird, wird von dem Mobilfunk-Betreiber hinsichtlich dieser Übermittlungen keine Fehler-Meldung an das sendende Alarmtelefon übermittelt.

Im Hinblick auf die Übergabestation 14 ist annahmegemäß jedoch die zugehörige Mobilfunk-Antenne nicht funktionsfähig, so dass der Mobilfunk-Betreiber die an das GSM-Modul 28 dieser Übergabestation 14 gerichtete Statusabfrage-SMS nicht zustellen kann. Dies hat zur Folge, dass der Mobilfunk-Betreiber hinsichtlich dieser Statusabfrage-SMS eine Fehler-Nachricht an das sendende Alarmtelefon übermittelt. Üblicherweise enthält eine derartige Fehler-Nachricht den Hinweis, dass "der Empfänger vorübergehend nicht erreichbar ist".

Im Umspannwerk 10 wird überwacht, ob der Mobilfunk-Betreiber eine der versendeten Statusabfrage-SMS's mit einer Fehler-Nachricht beantwortet. Eine derartige Fehler-Nachricht kann dann im Umspannwerk 10 dazu herangezogen werden, um auf den Ort des Kurzschlusses zu schließen.

So kann aus dem Empfang einer Fehler-Nachricht folgendes abgeleitet werden: Sofern im Umspannwerk 10 von einer bestimmten Übergabestation keine Kurzschluss-SMS eingeht, so kann daraus in einem ersten Schritt geschlossen werden, dass in dieser bestimmten Übergabestation auch kein Kurzschluss vorhanden ist. Sofern allerdings die an diese Übergabestation gerichtete Statusanfrage-SMS vom Mobilfunk-Betreiber mit einer Fehler-Nachricht beantwortet wird, muss daraus in einem zweiten Schritt gefolgert werden, dass von der bestimmten Übergabestation momentan gar keine Kurzschluss-SMS versendet werden kann. Dies ist jedoch gleichbedeutend damit, dass in der bestimmten Übergabestation, entgegen dem Ergebnis des ersten Schritts, doch ein Kurzschluss vorhanden sein kann. Auf dieser Grundlage kann dann die Ermittlung des Ortes des Kurzschlusses fortgesetzt werden.

Im vorliegend angenommenen Beispielfall wird von dem Mobilfunk-Betreiber eine Fehler-Nachricht als Antwort auf diejenige Statusabfrage-SMS versendet, die an das GSM-Modul 28 der Übergabestation 14 gerichtet war. Aus dieser empfangenen Fehler-Nachricht kann im Umspannwerk 10 abgeleitet werden, dass das GSM-Modul 28 der Übergabestation 14 momentan keine Kurzschluss-SMS versenden kann. Da jedoch das GSM-Modul 28 in der Übergabestation 14 mit der USV 32 versehen ist, kann angenommen werden, dass das GSM-Modul 28 als solches funktionsfähig ist. Daraus kann wiederum abgeleitet werden, dass die Funkverbindung zwischen dem GSM-Modul 28 und der zugehörigen Mobilfunk-Antenne 33 vermutlich nicht funktionsfähig ist. Dies kann schließlich auf eine fehlende Energieversorgung der Mobilfunk-Antenne 33 zurückgeführt werden, was seinerseits eine Folge eines Kurzschlusses in der die Mobilfunk-Antenne 33 mit Energie versorgenden Übergabestation 14 sein kann.

Insgesamt kann somit im Umspannwerk 10 aus dem Erhalt einer Fehler-Nachricht von dem Mobilfunk-Betreiber abgeleitet werden, dass diejenige Mobilfunk-Antenne aufgrund eines Kurzschlusses nicht funktionsfähig ist, die sich in der näheren örtlichen Umgebung derjenigen Übergabestation befindet, an die die zugehörige Kurzschluss-SMS gerichtet war. Mit Kenntnis derjenigen übergabestation, die die ausgefallene Mobilfunk-Antenne an sich mit Energie versorgt, kann damit auf die Übergabestation geschlossen werden, wo der Kurzschluss vermutlich vorhanden ist.

Damit ist es mit Hilfe der Statusabfrage-SMS's möglich, selbst bei kurzschlussbedingten Ausfällen von Mobilfunk - Antennen den Ort des Kurzschlusses festzustellen. Vom Umspannwerk 10 kann daraufhin eine gezielte Fehlerbehebung beispielsweise dadurch erfolgen, dass ein Elektriker direkt zum Ort des Kurzschlusses, also direkt zu der betreffenden Übergabestation geschickt wird, um dort den Kurzschluss zu beheben. Eine aufwändige Überprüfung aller Übergabestationen und eine Suche nach dem Ort des Kurzschlusses entfällt.

## Patentansprüche

1. Verfahren zum Ermitteln des Ortes eines Kurzschlusses in einer Leitung (11) eines Energieversorgungsnetzes, wobei die Leitung (11) mit mindestens einer Übergabestation (14) verbunden ist, und wobei in der Übergabestation (14) ein GSM-Modul (28) vorhanden ist, das in ein Mobilfunk-Netz eines Mobilfunk-Betreibers eingebucht werden kann, **dadurch gekennzeichnet, dass** das GSM-Modul (28) der übergabestation (14) fortlaufend in das Mobilfunk-Netz des Mobilfunk-Betreibers eingebucht ist, dass bei einem Kurzschluss eine Statusabfrage-SMS an das GSM-Modul (28) der Übergabestation (14) gesendet wird, dass überwacht wird, ob das Versenden der Statusabfrage-SMS mit einer Fehler-Nachricht des Mobilfunk-Betreibers beantwortet wird, und dass, sofern eine Fehler-Nachricht empfangen wird, der Ort des Kurzschlusses in Abhängigkeit von der erhaltenen Fehler-Nachricht ermittelt wird.

2. Verfahren nach Anspruch 1, **dadurch gekennzeichnet, dass** aus dem Empfang einer Fehler-Nachricht abgeleitet wird, dass diejenige Mobilfunk-Antenne (33) des Mobilfunk-Betreibers aufgrund des Kurzschlusses nicht funktionsfähig ist, die in der näheren örtlichen Umgebung der Übergabestation (14) vorhanden ist, an die die Statusabfrage-SMS gerichtet war, und dass der Ort des Kurzschlusses in Abhängigkeit von der nichtfunktionsfähigen Mobilfunk-Antenne (33) ermittelt wird.

3. Verfahren nach Anspruch 2, **dadurch gekennzeichnet, dass** der Ort des Kurzschlusses sich im Bereich derjenigen Übergabestation (14) befindet, von der die Mobilfunk-Antenne (33) an sich mit Energie versorgt wird.

4. Verfahren nach einem der vorstehenden Ansprüche, **dadurch gekennzeichnet, dass** ein Kurzschluss auf der Leitung (11) über dieselbe Leitung (11) gemeldet wird, und dass die Statusabfrage-SMS versendet wird, nachdem ein Kurzschluss über die Leitung (11) gemeldet worden ist.

5. Verfahren nach einem der vorstehenden Ansprüche, **dadurch gekennzeichnet, dass** ein Kurzschluss in der Übergabestation (14) erkannt werden kann, und dass bei einem erkannten Kurzschluss von dem GSM-Modul (28) der Übergabestation (14) eine Kurzschluss-SMS versendet wird.

6. Verfahren nach einem der vorstehenden Absprüche, **dadurch gekennzeichnet, dass** die Statusabfrage-SMS von einer Zentrale an das GSM-Modul (28) versendet wird, und dass die Überwachung auf eine Fehler-Nachricht und die Ermittlung des Orts des Kurzschlusses in Abhängigkeit von einer erhaltenen Fehler-Nachricht ebenfalls in der Zentrale durchgeführt wird.

7. Verfahren nach Anspruch 5 und 6, **dadurch gekennzeichnet, dass** die Kurzschluss-SMS von dem GSM-Modul (28) an die Zentrale versendet wird.

8. Vorrichtung zum Ermitteln des Ortes eines Kurzschlusses in einer Leitung (11) eines Energieversorgungsnetzes, wobei die Leitung (11) mit mindestens einer Übergabestation (14) verbunden ist, und wobei in der Übergabestation (14) ein GSM-Modul (28) vorhanden ist, das in ein Mobilfunk-Netz eines Mobilfunk-Betreibers eingebucht werden kann, **dadurch gekennzeichnet, dass** das GSM-Modul (28) der Übergabestation (14) mit einer unterbrechungsfreien Stromversorgung (32) gekoppelt und fortlaufend in das Mobilfunk-Netz des Mobilfunk-Betreibers eingebucht ist, dass Mittel vorgesehen sind, um bei einem Kurzschluss eine Statusabfrage-SMS an das GSM-Modul (28) der Übergabestation (14) zu senden, um zu überwachen, ob das Versenden der Statusabfrage-SMS mit einer Fehler-Nachricht des Mobilfunk-Betreibers beantwortet wird, und um, sofern eine Fehler-Nachricht empfangen wird, den Ort des Kurzschlusses in Abhängigkeit von der erhaltenen Fehler-Nachricht zu ermitteln.

9. Vorrichtung nach Anspruch 8, **dadurch gekennzeichnet, dass** die Mittel in einer Zentrale, insbesondere in einem Umspannwerk (10) untergebracht sind.

10. Vorrichtung nach Anspruch 8 oder 9, **dadurch gekennzeichnet, dass** in der Übergabestation (14) ein Kurzschlussanzeiger (21) und eine Steuereinheit (27) vorhanden sind, wobei die Steuereinheit (27) mit dem Kurzschlussanzeiger (21) und dem GSM-Modul (28) gekoppelt ist, dass der Kurzschlussanzeiger (21) dazu vorgesehen ist, einen Kurzschlussstrom auf der Leitung (11) zu erkennen, und dass die Steuereinheit (27) im Falle eines erkannten Kurzschlusses das GSM-Modul (28) derart ansteuert, dass eine Kurzschluss-SMS versendet wird.

11. Vorrichtung nach Anspruch 10, **dadurch gekennzeichnet, dass** die Kurzschluss-SMS Angaben enthält im Hinblick auf eine Phase, auf der der Kurzschluss aufgetreten ist, und/oder im Hinblick auf die Dauer des Kurzschlusses, oder dergleichen.

## Claims

1. A method for determining the location of a short circuit in a line (11) of an energy supply network, wherein the line is connected with at least one transfer station (14), and wherein a GSM module (28) is provided in the transfer station (14), which can be included in a mobile radio network of a mobile radio operator, **characterized in that** the GSM module (28) of the transfer station (14) is continuously tied into the mobile radio network of the mobile radio operator, that in case of a short circuit a status inquiry-SMS is transmitted to the GSM module (28) of the transfer station (14), that monitoring is performed as to whether the transmission of the status inquiry-SMS has been responded to by an error message from the mobile radio operator, and that, if an error message has been received. the location of the short circuit is determined as a function of the received error message.

2. The method in accordance with claim 1, **characterized in that** it is derived from a received error message that, because of the short circuit, the mobile radio antenna (33) of the mobile radio operator, which is located in the vicinity of the transfer station (14) to which the status inquiry-SMS had been directed, is incapable of functioning, and that the location of the short circuit will be determined as a function of the mobile radio antenna (33), which is incapable of functioning.

3. The method in accordance with claim 2, **characterized in that** the location of the short circuit lies in the area of that transfer station (14) from which the mobile radio antenna (33) is provided with energy per se.

4. The method in accordance with one of the preceding claims, **characterized in that** a short circuit in the line (11) is reported over the same line (11), and that the status inquiry-SMS is transmitted after a short circuit has been reported via the line (11).

5. The method in accordance with one of the preceding claims, **characterized in that** it is possible to detect a short circuit in the transfer station (14), and that in case of a detected short circuit a short circuit-SMS is transmitted by the GSM module (28) of the transfer station (14).

6. The method in accordance with one of the preceding claims, **characterized in that** the status inquiry-SMS is transmitted by a central station to the GSM module (28), and that monitoring for an error signal and the determination of the location of the short circuit as a function of a received error message is also performed in the central station.

7. The method in accordance with claim 5 and 6, **characterized in that** the short circuit-SMS is transmitted to the central station by the GSM module (28).

8. A device for determining the location of a short circuit in a line (11) of an energy supply network, wherein the line (11) is connected with at least one transfer station (14), and wherein a GSM module (28) is provided in the transfer station (14), which can be included in a mobile radio network of a mobile radio operator, **characterized in that** the GSM module (28) of the transfer station (14) is coupled with an interruption-free electric current supply (32) and is continuously included in the mobile radio network of the mobile radio operator, that, in case of a short circuit, means are provided for transmitting a status inquiry-SMS to the GSM module in order to monitor whether the transmission of the status inquiry-SMS had been responded to by an error message from the mobile radio operator and, provided an error message had been received, to determine the location of the short circuit as a function of the received error message.

9. The device in accordance with claim 8, **characterized in that** the means are housed in a central station, in particular in a sub-station.

10. The device in accordance with claim 8 or 9, **characterized in that** a short circuit indicator (21) and a control unit (27) are provided in the transfer station (14), and that the control unit (27) is coupled with the short circuit indicator (21) and the GSM module (28), that the short circuit indicator (21) is intended for the detection of a short circuit current on the line (11) and that, in case of a detected short circuit, the control unit (27) triggers the GSM module (28) in such a way that a short circuit SMS is transmitted.

11. The device in accordance with claim 10, **characterized in that** the short circuit SMS contains information in regard to a phase in which the short circuit has occurred, and/or in regard to the length of the short circuit, or the like.

## Revendications

1. Procédé pour déterminer le lieu d'un court-circuit dans une ligne (11) d'un réseau d'alimentation en énergie, ladite ligne (11) étant reliée à au moins une station de transfert (14), et un module GSM (28) étant présent dans la station de transfert (14), lequel module peut être référencé dans un réseau de téléphonie mobile d'un exploitant de téléphonie mobile, **caractérisé en ce que** le module GSM (28) de la station de transfert (14) est référencé en continu dans le réseau de téléphonie mobile de l'exploitant de téléphonie mobile, **en ce que**, en présence d'un court-circuit, un SMS de scrutation d'état est envoyé vers le module GSM (28) de la station de transfert (14), **en ce qu'**il est contrôlé si à l'envoi du SMS de scrutation d'état, il a été répondu par un message d'erreur de l'exploitant de téléphonie mobile, et **en ce que**, pour autant qu'un message d'erreur ait été reçu, le lieu du court-circuit est déterminé en fonction du message d'erreur reçu.

2. Procédé selon la revendication 1, **caractérisé en ce qu'**à partir de la réception d'un message d'erreur, on conclut un dysfonctionnement de l'antenne de téléphonie mobile (33) de l'exploitant de téléphonie mobile, qui est située dans l'environnement immédiat de la station de transfert (14) vers laquelle était envoyé le SMS de scrutation d'état, et **en ce que** le lieu du court-circuit est déterminé en fonction de l'antenne de téléphonie mobile (33) non apte à fonctionner.

3. Procédé selon la revendication 2, **caractérisé en ce que** le lieu du court-circuit se situe dans la zone de la station de transfert (14) qui fournit l'énergie à l'antenne de téléphonie mobile (33).

4. Procédé selon l'une quelconque des revendications précédentes, **caractérisé en ce qu'**un court-circuit sur la ligne (11) est signalé via la même ligne (11), et **en ce qu'**un SMS de scrutation d'état est envoyé après que le court-circuit ait été signalé via la ligne (11).

5. Procédé selon l'une quelconque des revendications précédentes, **caractérisé en ce qu'**un court-circuit peut être détecté dans la station de transfert (14), et **en ce qu'**en cas de détection d'un court-circuit, un SMS de court-circuit est envoyé par le module GSM (28) de la station de transfert (14).

6. Procédé selon l'une quelconque des revendications précédentes, **caractérisé en ce que** le SMS de scrutation d'état est envoyé depuis une centrale vers le module GSM (28), et **en ce que** le contrôle de présence d'un message d'erreur et la détermination du lieu de court-circuit sont effectués également dans la centrale en fonction d'un message d'erreur reçu.

7. Procédé selon les revendications 5 et 6, **caractérisé en ce que** le SMS de court-circuit est envoyé par le module GSM (28) vers la centrale.

8. Dispositif pour déterminer le lieu d'un court-circuit dans une ligne (11) d'un réseau d'alimentation en énergie, ladite ligne (11) étant reliée à au moins une station de transfert (14), et un module GSM (28) étant présent dans la station de transfert (14), lequel module peut être référencé dans un réseau de téléphonie mobile d'un exploitant de téléphonie mobile, **caractérisé en ce que** le module GSM (28) de la station de transfert (14) est couplé à une alimentation en énergie (32) exempte d'interruption, et est référencé en continu dans le réseau de téléphonie mobile de l'exploitant de téléphonie mobile, **en ce que** des moyens sont prévus pour envoyer, en présence d'un court-circuit, un SMS de scrutation d'état vers le module GSM (28) de la station de transfert (14), pour contrôler si à l'envoi du SMS de scrutation d'état, il a été répondu par un message d'erreur de l'exploitant de téléphonie mobile, et, pour autant qu'un message d'erreur ait été reçu, pour déterminer le lieu du court-circuit en fonction du message d'erreur reçu.

9. Dispositif selon la revendication 8, **caractérisé en ce que** les moyens sont logés dans une centrale, en particulier dans un poste de transformation (10).

10. Dispositif selon la revendication 8 ou 9, **caractérisé en ce qu'**un indicateur de court-circuit (21) et une unité de commande (27) sont présents dans la station de transfert (14), ladite unité de commande (27) étant couplée à l'indicateur de court-circuit (21) et au module GSM (28), **en ce que** l'indicateur de court-circuit (21) est prévu pour détecter un courant de court-circuit sur la ligne (11), et **en ce que** l'unité de commande (27), dans le cas d'un court-circuit détecté, commande le module GSM (28) de telle sorte qu'un SMS de court-circuit est envoyé.

11. Dispositif selon la revendication 10, **caractérisé en ce que** le SMS de court-circuit contient des informations concernant une phase dans laquelle le court-circuit s'est produit et/ou concernant la durée du court-circuit, ou tout élément similaire.
